# EUROPEAN PATENT APPLICATION

(11) **EP 4 206 008 A1**
(43) Date of publication of application: **05.07.2023**
(21) Application number: 23157439.3
(22) Date of filing: 01.12.2021
(51) Int. Cl.: B60H 1/00

(54) **AN IMPROVED COOLING SYSTEM FOR AN ELECTRONIC CONTROL UNIT OF A MOTOR VEHICLE**

(62) Divisional of application: 21211588.5
(71) Applicant: VOLVO TRUCK CORPORATION, 405 08 Göteborg (SE)
(72) Inventor: DHABU, Amit, Göteborg (SE); JAYESH, Jeet, 600010 Chennai (IN)
(74) Representative: Germain Maureau

(57) **Abstract**

The invention relates to a cooling system (10) for at least one electronic control unit (11) of a motor vehicle, the cooling system comprising a housing (12) for the at least one electronic control unit, the housing comprising an air circulation duct (14) configured to supply air to the at least one electronic control unit, characterized in that the air circulation duct comprises:
- a first inlet (16) configured to be connected to a vehicular air conditioning device (106), and
- a second inlet (18) configured to be connected to inside a driver's cab (101) of the motor vehicle.

## Description

### TECHNICAL FIELD

The invention relates to a cooling system for an electronic control unit (ECU) of a motor vehicle. The present disclosure also relates to a method for operating such a cooling system and to a corresponding computer program product.

The invention can be applied in heavy-duty vehicles, such as trucks, buses and construction equipment. Although the invention will be described with respect to a heavy-duty vehicle, the invention is not restricted to this particular vehicle, but may also be used in other vehicles such as passenger vehicles.

### BACKGROUND

Motor vehicles are equipped with numerous electrically controllable components, including everything from smaller electrical motors for operating windows, windscreen wipers and doors; actuators used in relation to the engine of the motor vehicle or for controlling elements of a break system; light sources for interior and/or exterior lighting; and similar. Typically, such electrically controllable components are activated/deactivated by a user operating an electrical switch, or automatically as a result of a determination made by electronic control units (ECU) integrated into the motor vehicle based on e.g. data received from monitoring sensors, the sensors also being integrated into the motor vehicle.

Typically, several electronic control units are integrated into an ECU compartment generally named fuse relay compartment (FRC), generally disposed in an electric center of the motor vehicle, for example behind the instrument panel (IP) of the motor vehicle, where other components such as vehicular air conditioning devices are located. The ECU compartment is a housing for at least one ECU, for example seven or more ECUs.

Electronic devices such as ECUs work reliably when they are at their respective operating temperatures, where "operating temperature" describes an allowed temperature range in which the ECU works optimally, without suffering any damage and in a high efficiency manner. Working reliably is indispensable especially in cases of ECU for controlling an electronic device used to promote driving safety.

Since ECUs dissipate heat when in operation, the more ECUs in an ECU compartment, the higher the temperature inside the ECU compartment. Therefore, especially with TEA3 architectures, it can be difficult to control the temperature inside the ECU compartment.

Under certain severe conditions, for example with high ambient temperature and/or strong sunlight, the increase of heat load can lead to temperatures of over 90-100°C in the electric center. Such high temperatures can result in degradation of ECUs performance and even failure. Therefore, the functioning of the motor vehicle can be altered.

It is very important to control the temperature around ECUs.

It is known to control the temperature of an ECU by using a cooling system comprising a device for extracting air from inside the motor vehicle, for example from a driver's cab or a cargo space, and for supplying the extracted air to the ECU.

The purpose of the invention is to improve the heat control inside the ECU compartment, and therefore to enable having numerous ECUs inside the ECU compartment.

### SUMMARY

An object of the invention is to provide a cooling system for at least one electronic control unit of a motor vehicle, which cooling system maintains an allowed temperature range in order to ensure reliable operation of the at least one electronic control unit

According to a first aspect of the invention, the object is achieved by a cooling system for at least one electronic control unit of a motor vehicle according to claim 1.

By the provision of a cooling system which comprises an air circulation duct comprising a first inlet configured to be connected to a vehicular air conditioning device, and a second inlet configured to be connected to inside a driver's cab of the motor vehicle, the heat control of the at least one electronic control unit is improved.

According to one embodiment, the first inlet comprises a first closing element movable between an open position and a closed position of the first inlet. Hereby the opening of the first inlet can be controlled.

According to one embodiment, the second inlet comprises a second closing element movable between an open position and a closed position of the second inlet. Hereby the opening of the second inlet can be controlled.

Therefore, an operator can select to supply air to the at least one electronic control unit from the driver's cab of the motor vehicle and/or from the vehicular air conditioning device.

According to a further embodiment, a fan is positioned within the air circulation duct. Hereby, the air circulation from the driver's cab of the motor vehicle and/or from the vehicular air conditioning device, to the at least one electronic control unit is enhanced.

According to one embodiment, the fan is disposed downstream the first and second inlets.

According to one embodiment, the second closing element is movable between the open and the closed position based on a suction force generated by the fan of the air circulation duct.

According to one embodiment, the first closing element is movable between the open and the closed position based on an airflow force generated by an airflow circulated from the vehicular air conditioning device.

According to a second aspect of the invention, the object is achieved by a motor vehicle according to claim 8.

According to one embodiment, the motor vehicle comprises a driver's cab, and the vehicular air conditioning device, the at least one electronic control unit and the cooling system are located in the driver's cab.

According to a third aspect of the invention, the object is achieved by a method according to claim 10.

According to one embodiment, the method is a method for cooling at least one electronic control unit of a motor vehicle via a cooling system as described above.

According to one embodiment, the method further comprises the step of controlling the first closing element based on an airflow force generated by an airflow circulated from the vehicular air conditioning device, and/or controlling the second closing element based on a suction force generated by the fan of the air circulation duct.

According to a fourth aspect of the invention, the object is achieved by a computer program according to claim 13.

According to one embodiment, the program code means is configured to operate the first and/or second closing elements of a cooling system as described above.

According to a fifth aspect of the invention, the object is achieved by a computer readable medium according to claim 15.

Further advantages and advantageous features of the invention are disclosed in the following description and in the dependent claims.

### BRIEF DESCRIPTION OF THE DRAWINGS

With reference to the appended drawings, below follows a more detailed description of embodiments of the invention cited as examples.

In the drawings:
Fig. 1 is a schematic perspective view of a dashboard of a motor vehicle, comprising a cooling system according to an embodiment of the invention, for at least one electronic control unit of the motor vehicle;
Fig. 2 is a schematic front view of the dashboard of figure 1, partly represented, showing the cooling system according to an embodiment of the invention;
Fig. 3 is a schematic top view of a cooling system according to an embodiment of the invention, the cooling system being connected to a vehicular air conditioning device;
Fig. 4 is a schematic perspective view of a cooling system according to an embodiment of the invention;
Fig. 5 is a schematic perspective view of the cooling system of figure 4, showing the first closing element in open position, and the second closing element in closed position;
Fig. 6 is a schematic perspective view of the cooling system of figure 4, showing the first closing element in closed position, and the second closing element in open position;
Fig. 7 is a schematic view of a motor vehicle comprising a cooling system according to an embodiment of the invention.

### DETAILED DESCRIPTION OF EXAMPLE EMBODIMENTS OF THE INVENTION

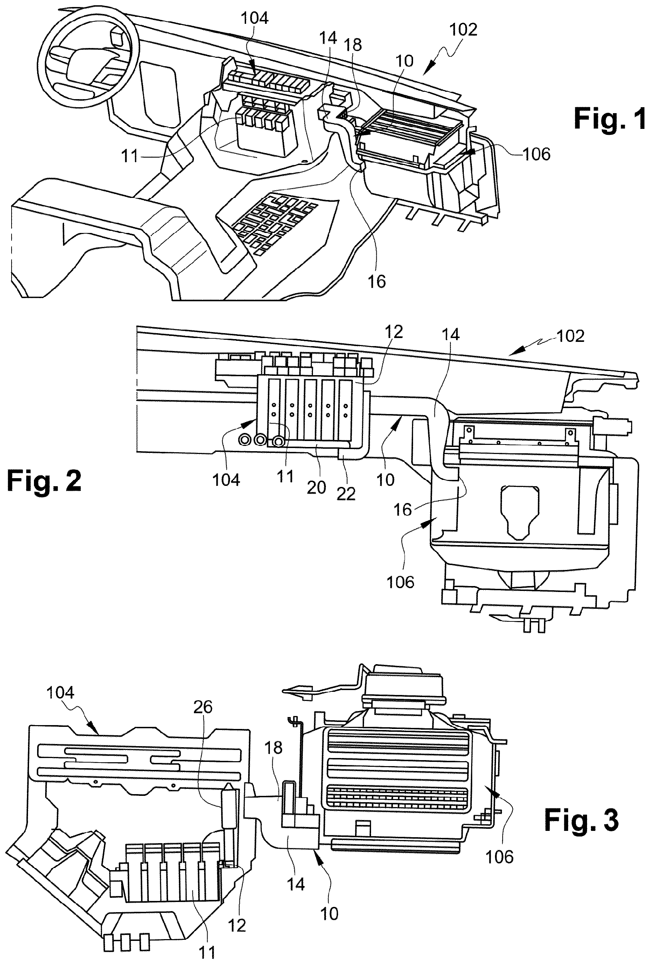

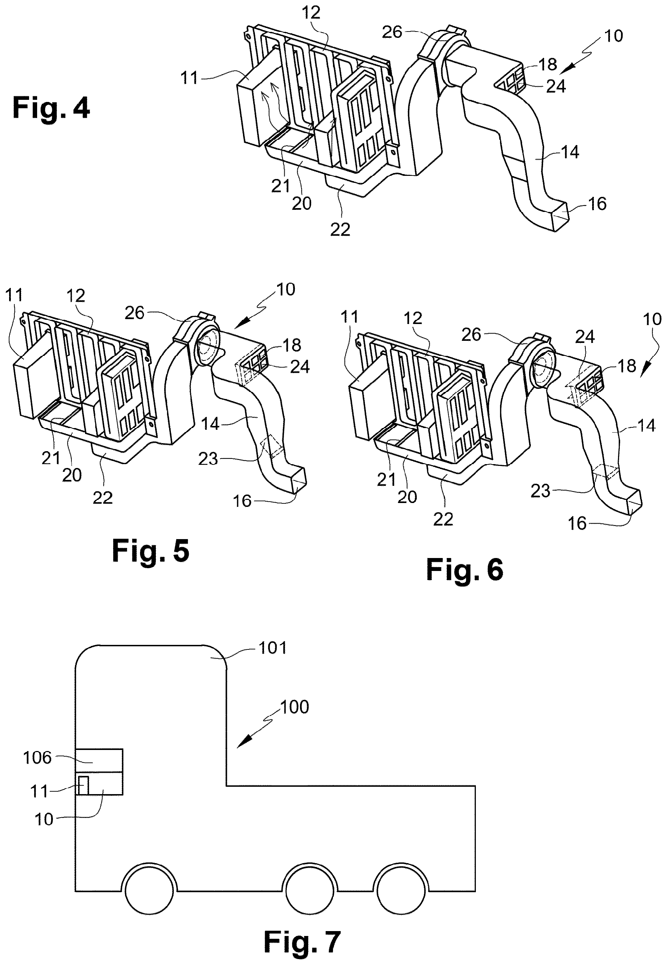

Figures 1 to 6 illustrate a cooling system 10 according to an embodiment of the invention. The cooling system 10 is a cooling system for at least one electronic control unit (ECU) 11 of a motor vehicle 100 (figure 7). For example, the cooling system 10 can be a cooling system for several ECUs 11, for example for three ECUs 11 (figures 4 to 6). For example, the cooling system 10 can be a cooling system for more than seven ECUs 11 (figure 1).

More particularly, figures 1 and 2 show a dashboard 102 of the motor vehicle 100. The dashboard 102 comprises an electric center 104 and a vehicular air conditioning device 106. The electric center 104 can be positioned behind an instrument panel (not shown). The electric center 104 can comprise at least one ECU 11. The vehicular air conditioning device 106 can be activated or deactivated, for example depending on the temperature of outside air. The vehicular air conditioning device 106 can be a HVAC.

As illustrated in figures 3 to 6, the cooling system 10 for the at least one ECU 11 comprises a housing 12 for the at least one ECU 11. An air circulation duct 14 can be connected to the housing 12 to supply air to the at least one ECU 11. The air circulation duct 14 can be configured to supply air to the housing 12. The housing 12 can comprise the air circulation duct 14.

More precisely, the air circulation duct 14 comprises:
- a first inlet 16 configured to be connected to the vehicular air conditioning device 106, and
- a second inlet 18 configured to be connected to inside a driver's cab 101 (figure 7) of the motor vehicle 100.

The air circulation duct 14 can comprise an air distribution compartment 20 configured to supply air to the at least one ECU 11. The air distribution compartment 20 can be configured to supply air to the housing 12. The air distribution compartment 20 of the air circulation duct 14 can comprise at least one opening 21 configured to supply air to the at least one ECU 11. The air distribution compartment 20 can comprise for example four openings 21. The air circulation duct 14 can comprise an air circulation area 22 emerging into the air distribution compartment 20, in order to supply air to the air distribution compartment 20. The air distribution compartment 20 can be placed below the electric center, for example below the housing 12.

The housing 12 can be a support for the at least one ECU 11. The housing 12 can be a support configured to maintain the at least one ECU and preferably several ECUs. The housing 12 can be a closed compartment in which the at least one ECU is disposed. The housing 12 can be named a distribution box.

The first inlet 16 can comprise a first closing element 23. The first closing element 23 can be movable between an open position (figure 5) and a closed position (figure 6) of the first inlet 16.

The second inlet 18 can comprise a second closing element 24. The second closing element 24 can be movable between an open position (figure 6) and a closed position (figure 5) of the second inlet 18.

The first closing element 23 and/or the second closing element 24 can be auto operative flaps, such as rubber flaps. The first closing element 23 and the second closing element 24 are configured to provide air flow to the at least one ECU 11, from different zones of the motor vehicle. More precisely, as described above, the first closing element 23 is configured to provide air flow to the at least one ECU 11 from the vehicular air conditioning device 106, and the second closing element 24 is configured to provide air flow to the at least one ECU 11 from the driver's cab 101.

A fan 26 can be positioned within the air circulation duct 14, preferably downstream the first inlet 16 and the second inlet 18, preferably upstream the distribution compartment. The fan 26 can be configured to generate a suction force of air. The fan 26 can be a booster fan. The fan 26 can operate at different speeds depending on airflow circulating in the air circulation duct 14. The fan 26 can therefore generate different suction forces of air, depending on the fan speed.

The first closing element 23 can be configured to move between the open and the closed position based on an airflow force generated by an airflow circulated from the vehicular air conditioning device 106. For example, the first closing element 23 can be in the open position if the airflow force is equal to or greater than a predetermined value. The predetermined value can be 3m/s or above.

The second closing element 24 can move between the open and the closed position based on the suction force generated by the fan 26 of the air circulation duct 14. For example, the second closing element 24 can be in the open position if the suction force is equal to or greater than a threshold. The threshold can be 2m/s.

Alternatively, the cooling system 10 can comprise a first controller (not represented) configured to move the first closing element 23 between the open position and the closed position. The cooling system 10 can comprise a second controller (not represented) configured to move the second closing element 24 between the open position and the closed position. The first controller and the second controller can be a unique controller (not represented). The unique controller can be configured to move the first closing element 23 and the second closing element 24 between the open position and the closed position.

Figure 7 illustrates a motor vehicle 100 comprising an air conditioning device 106 and at least one ECU 11. For example, the ECU can be an ECU for operating actuators used in relation to the engine of the motor vehicle or for controlling elements of a break system. Moreover, the motor vehicle 100 comprises a cooling system 10 for the at least one ECU 11. The motor vehicle 100 can comprise a driver's cab 101 comprising the air conditioning device 106, the at least one ECU 11 and the cooling system 10.

The cooling system 10 can operate according to a method comprising the steps of:
- blowing air from the vehicular air conditioning device 106 to the at least one ECU 11, and/or
- blowing air from inside the driver's cab 101 of the motor vehicle 100 to the at least one ECU 11.

The step of blowing air from the vehicular air conditioning device 106 to the at least one ECU 11 can be performed when the vehicular air conditioning device 106 is activated. The step of blowing air from the driver's cab 101 of the motor vehicle 100 to the at least one ECU 11 can be performed when the vehicular air conditioning device 106 is deactivated.

The cooling system 10 can be a cooling system 10 as described above. The method can comprise a step of controlling the first closing element 23 in the open position when the vehicular air conditioning device 106 is activated. The method can comprise a step of controlling the first closing element 23 in the closed position when the vehicular air conditioning device 106 is deactivated. The method can comprise a step of controlling the second closing element 24 in the closed position when the vehicular air conditioning device 106 is activated. The method can comprise a step of controlling the second closing element 24 in the open position when the vehicular air conditioning device 106 is deactivated.

Alternatively, the method can be performed via a cooling system comprising for example two air circulation ducts: a first air circulation duct connected to the air conditioning device 106, and a second air circulation duct connected to inside the driver's cab 101.

The motor vehicle 101 can comprise a computer program comprising program code means for performing the steps of the method for cooling at least one ECU as described above when said program is run on a computer. The program code means can be configured to operate the first 23 and/or second 24 closing elements of the cooling system 10.

The motor vehicle 101 can comprise a computer readable medium carrying a computer program comprising program code means for performing the steps of the method for cooling at least one ECU as described above when said program product is run on a computer.

The operation of the cooling system 10 as described above is now specified.

When the vehicular air conditioning device 106 is activated, cold air is drawn from the vehicular air conditioning device 106 and supplied to the at least one ECU, through the air circulation duct 14. The vehicular air conditioning device 106 generally comprises a blower. The fan 26 of the cooling system 10 can work in synchronization with the blower of the vehicular air conditioning device 106, in order to provide a desired cold airflow to the at least one ECU.

More precisely, when the vehicular air conditioning device 106 is activated, the cold air drawn from the vehicular air conditioning device 106, for example through the blower, generates an airflow force through the air circulation duct 14. The airflow force controls the opening of the first closing element 23. Moreover, when the vehicular air conditioning device 106 is activated, the second closing element 24 can be in the closed position. The second closing element 24 in the closed position ensures that there is no leakage of cold air. If the airflow force is lower than a predetermined value, the second closing element can be in the open position. If the airflow force is lower than the predetermined value, the fan speed is increased, and a suction force is generated by the fan. The suction force controls the opening of the second closing element 24.

When the vehicular air conditioning device 106 is deactivated, there is no cold air circulating from the vehicular air conditioning device 106, and the first closing element 23 is in the closed position. Therefore, the fan speed is increased, and a suction force is generated by the fan. The suction force controls the opening of the second closing element 24.

Alternatively, the first controller can be configured to move the first closing element 23 to the open position when the vehicular air conditioning device 106 is activated. The first controller can be configured to move the first closing element 23 to the closed position when the vehicular air conditioning device 106 is deactivated. The second controller can be configured to move the second closing element 24 to the closed position when the vehicular air conditioning device 106 is activated. The second controller can be configured to move the second closing element 24 to the open position when the vehicular air conditioning device 106 is deactivated.

Alternatively, the unique controller can be configured to move the first closing element 23 to the open position and the second closing element 24 to the closed position, when the vehicular air conditioning device 106 is activated. The unique controller can be configured to move the first closing element 23 to the closed position and the second closing element 24 to the open position, when the vehicular air conditioning device 106 is deactivated.

It is to be understood that the present invention is not limited to the embodiments described above and illustrated in the drawings; rather, the skilled person will recognize that many changes and modifications may be made within the scope of the appended claims.

## Claims

1. A cooling system (10) for at least one electronic control unit (11) of a motor vehicle (100), the cooling system (10) comprising a housing (12) for the at least one electronic control unit (11), the housing (12) comprising an air circulation duct (14) configured to supply air to the at least one electronic control unit (11), **wherein** the air circulation duct (14) comprises:
- a first inlet (16) configured to be connected to a vehicular air conditioning device (106), the first inlet comprising a first closing element (23) movable between an open position and a closed position of the first inlet (16), and
- a second inlet (18) configured to be connected to inside a driver's cab (101) of the motor vehicle (100),
- a fan (26) being positioned within the air circulation duct (14), downstream the first (16) and second (18) inlets,
**characterized in that** the first closing element (23) is movable between the open and the closed position based on an airflow force generated by an airflow circulated from the vehicular air conditioning device (106).

2. The cooling system according to claim 1, wherein the second inlet (18) comprises a second closing element (24) movable between an open position and a closed position of the second inlet (18).

3. The cooling system according to 2,wherein the second closing (24) element is movable between the open and the closed position based on a suction force generated by the fan (26) of the air circulation duct (14).

4. A motor vehicle (100) comprising a vehicular air conditioning device (106) and at least one electronic control unit (11), the motor vehicle (100) comprising a cooling system (10) according to any of the preceding claims.

5. The motor vehicle (100) according to the preceding claim, wherein the motor vehicle (100) comprises a driver's cab (101), and wherein the vehicular air conditioning device (106), the at least one electronic control unit (11) and the cooling system (10) are located in the driver's cab (101).

6. A method for cooling at least one electronic control unit (11) of a motor vehicle (100), via a cooling system (10) comprising a housing (12) for the at least one electronic control unit (11), the housing (12) comprising an air circulation duct (14) configured to supply air to the at least one electronic control unit (11), the air circulation duct (14) further comprising:
- a first inlet (16) configured to be connected to a vehicular air conditioning device (106), the first inlet comprising a first closing element (23) movable between an open position and a closed position of the first inlet (16), and
- a second inlet (18) configured to be connected to inside a driver's cab (101) of the motor vehicle (100),
- a fan (26) being positioned within the air circulation duct (14), downstream the first (16) and second (18) inlets,
wherein the method comprises the steps of:
- blowing air from a vehicular air conditioning device (106) to the at least one electronic control unit (11), and/or
- blowing air from inside a driver's cab (101) of the motor vehicle (100) to the at least one electronic control unit (11),
**characterized by** a further step of controlling the first closing element (23) based on an airflow force generated by an airflow circulated from the vehicular air conditioning device (106).

7. The method according to claim 10, for cooling at least one electronic control unit (11) of a motor vehicle (100) via a cooling system (10) according to any of claims 1 to 3.

8. The method according to claim 6, wherein a second closing element (24) is movable between an open position and a closed position of the second inlet (18), and wherein the step of blowing air from inside a driver's cab (101) is implemented through the second inlet (18) of the air circulation duct (14),
**characterized by** a further step of controlling the second closing element (24) based on a suction force generated by the fan (26) of the air circulation duct (14).

9. A computer program comprising program code means for performing the steps of any of claims 6 to 8 when said program is run on a computer.

10. A computer readable medium carrying a computer program comprising program code means for performing the steps of any of claims 6 to 8 when said program product is run on a computer.
